# EUROPEAN PATENT APPLICATION

(11) **EP 2 327 673 A1**
(43) Date of publication of application: **01.06.2011**
(21) Application number: 09816131.8
(22) Date of filing: 18.09.2009
(51) Int. Cl.: C04B 35/00, C23C 14/08, H01B 1/08, H01B 5/14, H01B 13/00

(54) **OXIDE SINTERED COMPACT FOR PRODUCING TRANSPARENT CONDUCTIVE FILM**

(30) Priority: 25.09.2008 JP 2008246504
(71) Applicant: JX Nippon Mining & Metals Corporation, Chiyoda-ku Tokyo 100-0004 (JP)
(72) Inventor: IKISAWA, Masakatsu, Kitaibaraki-shi Ibaraki 319-1535 (JP); YAHAGI, Masataka, Kitaibaraki-shi Ibaraki 319-1535 (JP)
(74) Representative: Peguet, Wilfried
(86) International application number: PCT/JP2009/066394
(87) International publication number: WO 2010/035716

(57) **Abstract**

The present invention provides an ITO amorphous transparent conductive film used in a display electrode for a flat panel display or the like, which can be produced without heating a substrate and without feeding water during the sputtering, while achieving both high etchability and lower resistivity at high levels. An oxide sintered compact containing indium oxide as a main component, while containing one or more elements selected from nickel, manganese, aluminum and germanium as a first additive element, with the total content of the first additive element being 2-12 atom % relative to the total content of indium and the first additive element.

## Description

### BACKGROUND OF THE INVENTION

### [Field of the Invention]

The present invention relates to an oxide sintered compact for preparing a transparent conductive film formed as an electrode in a flat panel display or the like. It also relates to a transparent conductive film obtained by using said oxide sintered compact as a sputtering target and a method for preparing the transparent conductive film.

### [Description of the Related Art]

An ITO (Indium Tin Oxide) film is characterized in low resistivity and high transmission factor, and can be microfabricated easily. Since these characteristics are superior in comparison to other transparent conductive films, an ITO film is being broadly used in various fields including for use as a display electrode in a flat panel display. The deposition method of the ITO film in today's industrial production process is mostly based on the so-called sputter deposition method of performing sputtering using an ITO sintered compact as the target since the ITO film can be uniformly formed on a large area with favorable productivity.

In a flat panel display manufacture process using an ITO transparent conductive film, the crystallinity of the ITO film immediately after the sputtering is amorphous, and, in many cases, microfabrication such as etching is performed with the ITO film in an amorphous state, and thermal annealing is subsequently performed to crystallize the ITO film. This is because an ITO amorphous film is advantageous in terms of productivity due to much higher etching rate than an ITO crystalline film, while the ITO crystal film is superior in low resistivity, and both advantages can thereby be enjoyed.

Although most part of the film obtained by sputtering the ITO target is amorphous, in many cases a part of the film becomes crystallized. The reason for this is that although most part of the film remains amorphous since the temperature will become no more than 150°C, which is approximate to the crystallization temperature of the ITO film, particles that come flying to the substrate by sputtering sometimes have a high energy level and the temperature of the film becomes so high as to exceed the crystallization temperature due to the transfer of energy after the particles arrive at the substrate, resulting in crystallization of a part of the film.
If a part of the ITO film becomes crystallized in this way, such crystallized portion will remain as so-called etching residue in the subsequent etching process, and cause problems such as a short circuit, since the etching rate of that part will be lower than that of an amorphous portion by roughly two orders of magnitude.

In light of the above, it is known that the addition of water (H₂O) in addition to sputter gas such as argon in a chamber during sputtering is effective as a method of preventing the crystallization of the sputtered film and amorphizing the entire sputtered film (for example, refer to Non-Patent Document 1).
Nevertheless, the method of adding water when sputtering to obtain an amorphous film entails numerous problems. Foremost, in many cases particles are generated on the sputtered film. These particles have an adverse effect on the flatness and crystallinity of the sputtered film. Since particles will not be generated if water is not added, the problem of generation of particles is caused by adding water.

In addition, even if the water concentration in the sputtering chamber is initially adequate, the concentration will gradually fall below the adequate concentration, and a part of the sputtered film will become crystallized, since it gradually decreases during the lapse of the sputtering time.
On the other hand, however, if the concentration of the water to be added is increased in order to reliably obtain an amorphous sputtered film, the crystallization temperature for crystallizing the film in the subsequent annealing process will become extremely high, causing a problem that the resistivity of the obtained film will become extremely high.
In other words, if sputtering is performed with adding water to amorphize the entire sputtered film, it is necessary to constantly monitor and control the water concentration within the chamber, however, this is extremely difficult and requires considerable time and effort.

In order to overcome the foregoing problems, a transparent conductive material which is stably amorphous is partly used in substitute for an ITO film which readily becomes crystallized. For instance, it is known that an amorphous film can be obtained by sputtering a target having a composition of indium oxide and an added amount of zinc, but the sputtered films obtained thereby have resistivity of about 0.5 mΩ cm, which is higher than the crystallized ITO film. Moreover, the visible light average transmission factor of this film is roughly 85%, and is inferior to that of ITO films.

As prior art disclosing that amorphous films can be obtained without adding water and/or zinc, the following are referred to.

Patent Document 1 describes a transparent conductive film which is mainly comprised of indium oxide and tin oxide, and includes an oxide of at least one metal selected from the group consisting of magnesium and nickel. In this way, the film becomes fine, increasing electron mobility to about 1.5 × 10 cm²· s⁻¹ · V⁻¹. Further, Document 1 also discloses that resistance to humidity and ultraviolet rays can be improved by optimizing the ratio of magnesium or nickel. Document 1 teaches that a formulating proportion of magnesium compound or nickel compound to indium compound in terms of the formula represented by M / (M + In) (M is nickel or magnesium, and In is indium) is preferably 0.05 or less,

Patent Document 2 discloses that specific resistance of a transparent conductive film is reduced by adding nickel oxide to indium oxide. The amount of nickel oxide to be added is preferably defined as 2-25mol% to achieve the specific resistance of 2 × 10⁻⁴ Ω cm or less.

Patent Document 3 discloses a target containing an insulating oxide in addition to indium oxide or indium tin oxide, in order to provide an indium oxide system sputtering target for the highly resistant transparent conductive film with the resistivity of about 0.8-10× 10⁻³ Ω cm. As one example of an insulating oxide, manganese oxide is mentioned. However, Patent Document 3 does not describe any sputtering targets for obtaining a low resistant conductive film.

Patent Document 4 discloses a target adding Mn to indium oxide or indium tin oxide since Mn containing in the sintered compact made of indium oxide and tin oxide will enable an extremely high sintered density. It is described that the content of Mn is adjusted to 5 to 5000ppm Mn in the ITO sintered body finally obtained. The content of Mn is preferably 10~500ppm. In Examples, it was added 500 ppm at most.

Patent Document 5 discloses that resistivity of a transparent conductive film reduces by adding manganese oxide into indium oxide. According to the document, when 2-15 mol % of manganese oxide is added, the film has preferably resistivity of less than 2×10⁻⁴ Ω cm.

Patent Document 6 discloses a film comprised of indium oxide and further containing trivalent cation, an example thereof being aluminum. Patent Document 6 teaches that a transparent conductive film having lower resistance and improved etching workability is thus obtained. However, the object of the Patent Document 6 is to obtain the film with low resistance and excellent workability by preventing the reduction of mobility due to scattering of ionized impurities. As the working example, only an example with yttrium is given. Accordingly, it is not clear at all whether the aluminum has the effect insisted in Document 6 or not.

Patent Document 7 teaches "A transparent conductive film predominantly comprising of the oxide of In, furthermore containing Ge, or Ge and Sn can be amorphous, and thereby is easy to be etched and excellent in workability" (Paragraph 0015). This is because that "under certain film forming conditions, adding Ge is effective for amorphizing In₂O₃ film and said addition does not have any bad influence upon the electric resistivity and transmission factor" (Paragraph 0021). Such film forming conditions are that "the film forming temperature is adjusted to 100-300°C, and 2-12 atomic percent of Ge is added based on the total amount of Ge and In, and the oxygen partial pressure is kept at 0.02 mTorr or more when the film is formed"(Paragraph 0029). It is also described that "During the formation of the film, if the film forming temperature is below 100°C, and the amount of Ge added is less than 2 atomic percent, reduction of the electric resistivity due to carrier electron release by Ge is not sufficient, and therefore the electric resistivity is more than 0.01 Ω cm"(Paragraph 0030).

### [Prior Art Documents]

### <Patent Document>

Patent Document 1: H07-161235A
Patent Document 2: H03-71510A
Patent Document 3: JP2003-105532A
Patent Document 4: JP 3496239B
Patent Document 5: JP H03-78907A
Patent Document 6: H08-199343A
Patent Document 7: JP 3780100B

### <Non-Patent Document>

Non-Patent Document 1: Thin Solid Films 445 (2003) p235-240

### SUMMARY OF THE INVENTION

### [Problems to be Solved by the Present Invention]

As described above, the conventional technology which uses as a target a sintered compact having a composition in which zinc is added to indium oxide is insufficient as a solution since it has drawbacks such as high film resistivity.

Moreover, in any one of the patent documents 1-7, a transparent conductive film which satisfies both of superior etching properties and the low resistivity has not yet been obtained, and therefore there is still room for improvement.

Thus, the problem to be solved by the present invention is to provide an ITO amorphous transparent conductive film used for a display electrode or the like in a flat panel display, which can be prepared without heating a substrate or adding water during deposition, which satisfies both of superior etching properties and low resistivity in a high order. Further, another object of the present invention is to provide a sputtering target which makes it possible to produce such a transparent conductive film.

### [Means for Solving the Problem]

As a result of intense study regarding an oxide target obtained by adding various elements to indium oxide or indium tin oxide, the present inventors have found a technical idea that addition of proper concentration of an appropriate dopant(s) gives an increase of the etching rate and a decrease of the resistivity of the film, and thus found that a transparent conductive film capable of solving the foregoing problems can be obtained by sputtering a sintered compact in which an adequate concentration of nickel and the like is added to indium oxide or indium tin oxide under a prescribed condition, and thereby completing the present invention.

The present invention may be specified, on the basis of such findings, as described below.

1) An oxide sintered compact containing indium oxide as a main component, while containing one or more elements selected from nickel, manganese, aluminum and germanium as a first additive element, with the total content of the first additive element being 2-12 atom % relative to the total content of indium and the first additive element.

2) An oxide sintered compact containing indium oxide as a main component, while containing one or more elements selected from nickel, manganese, aluminum and germanium as a first additive element, and further containing tin as a second additive element, with the total content of the first additive element being 2-12 atom % relative to the total content of indium, the first additive element and tin, and the content of tin being 2-15 atom % relative to the total content of indium and tin.

3) A method of producing an amorphous film, wherein the sintered compact according to 1) or 2) above is used as a sputtering target and is sputtered.

4) An amorphous film having the same composition as that of the sintered compact according to 1) or 2) above.

The first feature of the present invention is that the added nickel and the like prevent from crystallization through the effect of disconnecting the network coupling structure of indium oxide and the like. The second feature of the present invention is that such a dopant(s) which promote(s) the amorphization contribute(s) to reducing the resistivity of the film as well as improving the etching properties. Further, as the third feature, the addition of tin makes it possible to promote reduction of the resistivity of the film.

### [Effect of the invention]

According to the present invention, using a sputtering target obtained by adding an adequate concentration of nickel or the like to indium oxide or the like, it is possible to obtain a film which is entirely amorphous by sputtering the target under a prescribed condition without adding water during deposition or heating a substrate. The film obtained is entirely amorphous, superior in terms of productivity due to a high etching rate, and appropriate as a transparent conductive film since it has a low resistivity.

### DETAILED DESCRIPTION OF THE EMBODIMENT OF THE INVENTION

### Composition of the oxide sintered compact and the transparent conductive film

Nickel, manganese, aluminum and germanium as the first additive element have an amorphizing effect by inhibiting the crystallization of films when added to indium oxide or indium tin oxide. The additive element may be solely added or two or more elements may be added. However, when the total content of the first additive element is too small relative to the total content of indium and the first additive element (the total content of indium and the first additive element and tin, in the case where tin is doped), there will hardly be any effect of amorphizing the film, and a part of the sputtered film will become crystallized. Therefore, the etching rate reduces to generate the etching residue. Contrarily, in case where the total content of the first additive element is too much relative to the total content of indium and the first additive element (and tin), the resistivity of the amorphous film will become high.

Therefore, the total content of the first additive element may be 2-12 atom % relative to the total content of indium and the first additive element (and tin). For obtaining a low resistivity of the film, 4-8 atom % is preferable, and 5-7 atom % is more preferable.

Among the first additive elements, nickel is preferable. This is because nickel has an increased effect of lowering the resistivity of the amorphous film in comparison to other first additive elements, and has a high effect of elevating the etching rate.

Tin, when added to indium oxide, works as an n-type donor and yields the effect of lowering the resistivity. In a commercially available ITO target and the like, the tin concentration (Sn) is normally about 10 atom % relative to the total amount of the indium and the tin. If the tin concentration is too low, the electron donation will be small. Contrarily, if the tin concentration is too high, it will become electron scattered impurities. In both cases, the resistivity of the film obtained by sputtering will become high. Accordingly, the appropriate range of the tin concentration (Sn) for an ITO is 2-15 atom % relative to the total amount of the indium and the tin, and preferably, 8-12 atom %.

### The method of producing the oxide sintered compact

The method of producing the oxide sintered compact is now explained.
In order to produce the oxide sintered compact of the present invention, foremost, an indium oxide powder, an oxide powder of the first additive element and, if necessary, a tin oxide powder as the raw materials are weighed and mixed at a prescribed ratio. Insufficient mixing will cause a high resistivity area and a low resistivity area in the produced target where the first additive element is segregated and abnormal discharge such as arcing due to electrification in the high resistivity area will occur easily during the sputter deposition. Although the raw materials which is non-oxide form may be used, oxide is preferable in view of handling.

Thus, it is desirable to perform sufficient mixing for roughly 2 to 5 minutes at a high speed of 2000 to 4000 rotations per minute using a super mixer. Incidentally, since the raw material powders are oxide, the atmospheric gas may be air since there is no need to give special consideration for preventing the oxidation of the raw materials.

At this stage, it is also effective to introduce a calcination process of retaining the raw material in an atmospheric environment at 1250 to 1350°C for 4 to 6 hours in order to promote solid solution among the raw materials. Further, Calcination may be performed to a mixed powder of the indium oxide and the oxide of the first additive element.

The mixed powder is subsequently pulverized, aiming to uniformly distribute the raw material powder in the target. Raw material with a large grain size means that there is variation in the composition depending on the location.

Accordingly, pulverization is desirably performed until the average grain size (D50) of the raw material powder gets1µm or less, preferably 0.6µm or less. In reality, water is added to the mixed powder to obtain slurry with the solid content of 40 to 60wt%, and pulverization is performed with zirconia beads having a diameter of 1 mm for roughly 1.5 to 3.0 hours.

Granulation of the mixed powder is subsequently performed. Granulation is performed to improve the fluidity of the raw material powder and to make the filling state of such raw material powder during the press molding sufficiently favorable. PVA (polyvinyl alcohol) that acts as a binder is mixed at a ratio of 100 to 200cc per kilogram of slurry, and the mixed powder is granulated under the conditions where the granulator's inlet temperature is 200 to 250°C, outlet temperature is 100 to 150°C, and disk rotation is 8000 to 10000 rpm.

Press molding is subsequently performed. Granulated powder is filled in a mold of a prescribed size at a surface pressure of 700 to 900kgf/cm² to obtain a compact. If the surface pressure is 7 less than 00kgf/cm², it is not possible to obtain a compact having sufficient density. The surface pressure of more than 900kgf/cm² is not necessary and this is undesirable in terms of productivity since it will also require wasteful cost and energy.

Sintering is ultimately performed. The sintering temperature is 1450 to 1600°C, the retention time is 4 to 10 hours, the temperature increase rate is 4 to 6°C/minute, and cooling is performed with furnace cooling. If the sintering temperature is lower than 1450°C, the density of the sintered compact will be insufficient, and if the sintering temperature exceeds 1600°C, it will shorten the life of the furnace heater. If the retention time is shorter than 4 hours, the reaction among the raw material powders will not advance sufficiently, and the density of the sintered compact will be insufficient. If the sintering time exceeds 10 hours, since the reaction is already sufficient, this is undesirable from the perspective of productivity since energy and time will be wasted.
If the temperature increase rate is less than 4°C/minute, much time will be required in attaining a prescribed temperature. Meanwhile, if the rate of temperature increase is greater than 6°C/minute, the temperature will not rise with a uniform temperature distribution within the furnace, and there will be unevenness. The relative density of the sintered compact obtained as described above will be 98-100% e.g., approximately 99.9% and the bulk resistance will be about 0.1-3.0 m Ω cm e.g., approximately 0.13m Ω cm.

### The method of producing the sputtering target

The method of producing the sputtering target is explained below.
The oxide sintered compact obtained under the foregoing manufacturing conditions can be subjected to cylindrical grinding of the outer periphery side and surface grinding of the circular surface to be processed into a size having a thickness of roughly 4 to 6mm and a diameter to fit the sputtering device. Then, it can be laminated to a backing plate made of copper using a bonding metal such as indium alloy to obtain a sputtering target.

The sputtering deposition method is explained below.
The transparent conductive film of the present invention can be obtained by using the sputtering target of the present invention to perform sputter deposition with an argon gas pressure of 0.4 to 0.8Pa, spacing between the target and the substrate at 50 to 110mm, using glass or the like as the substrate without heating the substrate, and a sputtering power (e.g. for the target size of 8 inches) of 200 to 900W Sputter type is preferably DC magnetron sputter.

If the spacing between the target and the substrate is shorter than 50mm, the kinetic energy of the particles of the constituent elements of the target that reach the substrate will become too large and cause substantial damage to the substrate, whereby the film resistivity will increase and a part of the film may become crystallized. Meanwhile, if the spacing between the target and the substrate is longer than 110mm, the kinetic energy of the particles of the constituent elements of the target that reach the substrate will become too small, whereby a dense film cannot be formed and resistivity will become high. The adequate range of the argon gas pressure and the sputtering power is defined as described above for similar reasons. Moreover, if the substrate is heated, the film tends to crystallize easily. Accordingly, the obtained film will become amorphous by adequately selecting the foregoing sputtering conditions.

### The method of evaluating the characteristics of the film

The method of evaluating the characteristics of the film is now explained.
The determination of crystallinity of the transparent conductive film obtained as described above can be confirmed based on the existence of a peak appeared with a crystalline film in the X-ray diffraction measurement (XRD measurement) of the film and whether there is etching residue appeared in case of a crystalline film after the etching of the film with oxalic acid. In other words, if there is no peak that is unique to ITO crystals in the X-ray diffraction measurement and there is no etching residue, then that film can be determined to be amorphous.

The etching method of the film using oxalic acid can be performed, for instance, by using as an etchant a solution obtained by mixing oxalic acid dihydrate (COOH)₂· 2H₂O and purified water at a weight ratio of oxalic acid:purified water = 5:95, placing in a constant temperature bath so as to maintain the liquid temperature at 40°C, and stirring the film-attached substrate.

Further, the resistivity of the film can be measured with Hall measurement.. The amorphous films related to the present invention may have the resistivity of 1.8 m Ω cm or less, preferably, 1.0 m Ω cm or less, and more preferably, 0.6 m Ω cm or less. For example, the film has a resistivity of 0.1-0.6 m Ω cm.

### [Examples]

The present invention is now explained in detail with reference to the Examples. These Examples are merely illustrative, and the present invention shall in no way be limited thereby. In other words, various modifications and other embodiments within the technical spirit in the claims shall be included in the present invention.

### (Example 1)

Indium oxide (In₂O₃) powder and nickel oxides (NiO) powder, as the raw materials were weighed to achieve In:Ni = 98:2 based on the atomicity ratio, and mixed with a super mixer in an atmospheric environment for 3 minutes at 3000 rotations per minute.
Subsequently, water was added to the mixed powder to obtain slurry with the solid content of 50%, and the slurry was pulverized with zirconia beads having a diameter of 1 mm for 2 hours to achieve an average grain size (D50) of the mixed powder of 0.6µm or less. PVA (polyvinyl alcohol) was thereafter mixed at a ratio of 125cc per kilogram of slurry, and granulated under the conditions where the granulator's inlet temperature was 220°C, outlet temperature was 120°C, and disk rotation was 9000rpm.

Subsequently, granulated powder was filled in a mold of a prescribed size to obtain a target having an 8-inch diameter, and pressed at a surface pressure of 780kgf/cm² to obtain a compact. The compact was sintered by heating up to 1540°C at a temperature increase rate of 5 °C/minute, retaining for 5 hours at 1540°C, and cooling by furnace cooling.
The oxide sintered compact obtained under the foregoing conditions was subjected to cylindrical grinding of the outer periphery side and surface grinding of the circular surface to realize a thickness of roughly 5mm and a diameter of 8 inches. Then, it was laminated to a backing plate made of copper using indium as a bonding metal to obtain a sputtering target.

The foregoing sputtering target was equipped to SPF-313H sputtering device (Canon-anelva.co.) and used to perform DC magnetron sputter deposition with an argon gas pressure of 0.5Pa, spacing between the target and the substrate at 80mm, using non-alkali glass as the substrate, and, with the substrate in a non-heated state, and sputtering power of 785W and deposition time of 22 seconds in order to obtain a film having a film thickness of approximately 550Å. As a result of conducting XRD measurement of the foregoing film, a peak showing crystallinity could not be acknowledged. The film was amorphous.
Moreover, the film was subjected to etching using as an etchant a solution obtained by mixing oxalic acid and purified water at a weight ratio of oxalic acid:purified water = 5:95, but no etching residue was acknowledged.

The resistivity of said film was 1.2 m Ω cm and etching rate was 15 Å/sec. The results of the film are shown in Table 1. The transmittance at wavelength of 550 nm was 90%.

### (Examples 2-30)

The sintered compact composition of Example 1 was changed in Examples 2 to 30, as shown in Table 1, while the other conditions are the same as Example 1. In all of these cases, after deposition, the films were amorphous and transparent and there was no etching residue. Manganese oxide (Mn₂O₃), as a source of Mn, aluminum oxide (Al₂O₃), as a source of Al, and germanium oxide (GeO₂), as a source of germanium were used respectively.

In these Examples, each of the films after deposition was amorphous, and when nickel, manganese, aluminum, germanium and nickel together with manganese were added, the resistivity of the film reduced once and then increased together with the increase in the concentration of each dopant or the total concentration of dopants. The minimum resistivity was given at about 6 at% of the dopant concentration. The resistivity of these films was adequately low, which were comparable to that of ITO film, and therefore they were adequate as a transparent conductive film.
On the other hand, the etching rate of the films increased monotonously as the addition amount of each dopant increased.

**[Table 1]**

| | Sintered compact comp. (atomic %) | | | | | | Rate (Atom %) | Resistivity (mΩ cm) | Etching Rate (Å/sec) |
|---|---|---|---|---|---|---|---|---|---|
| | In | Ni | Mn | Al | Ge | Sn | A | | |
| Ex. 1 | 98.0 | 2.0 | 0.0 | 0.0 | 0.0 | 0.0 | 2.0 | 1.2 | 15 |
| Ex. 2 | 96.0 | 4.0 | 0.0 | 0.0 | 0.0 | 0.0 | 4.0 | 0.8 | 18 |
| Ex. 3 | 94.0 | 6.0 | 0.0 | 0.0 | 0.0 | 0.0 | 6.0 | 0.4 | 21 |
| Ex. 4 | 92.0 | 8.0 | 0.0 | 0.0 | 0.0 | 0.0 | 8.0 | 0.8 | 24 |
| Ex. 5 | 90.0 | 10.0 | 0.0 | 0.0 | 0.0 | 0.0 | 10.0 | 1.2 | 27 |
| Ex. 6 | 88.0 | 12.0 | 0.0 | 0.0 | 0.0 | 0.0 | 12.0 | 1.6 | 30 |
| Ex. 7 | 98.0 | 0.0 | 2.0 | 0.0 | 0.0 | 0.0 | 2.0 | 1.4 | 15 |
| Ex. 8 | 96.0 | 0.0 | 4.0 | 0.0 | 0.0 | 0.0 | 4.0 | 1.0 | 17 |
| Ex. 9 | 94.0 | 0.0 | 6.0 | 0.0 | 0.0 | 0.0 | 6.0 | 0.6 | 19 |
| Ex. 10 | 92.0 | 0.0 | 8.0 | 0.0 | 0.0 | 0.0 | 8.0 | 1.0 | 22 |
| Ex. 11 | 90.0 | 0.0 | 10.0 | 0.0 | 0.0 | 0.0 | 10.0 | 1.4 | 25 |
| Ex. 12 | 88.0 | 0.0 | 1 2.0 | 0.0 | 0.0 | 0.0 | 12.0 | 1.8 | 28 |
| Ex. 13 | 98.0 | 0.0 | 0.0 | 2.0 | 0.0 | 0.0 | 2.0 | 1.4 | 15 |
| Ex. 14 | 96.0 | 0.0 | 0.0 | 4.0 | 0.0 | 0.0 | 4. 0 | 1.0 | 17 |
| Ex. 15 | 94.0 | 0.0 | 0.0 | 6.0 | 0.0 | 0.0 | 6.0 | 0.6 | 19 |
| Ex. 16 | 92.0 | 0.0 | 0.0 | 8.0 | 0.0 | 0.0 | 8.0 | 1.0 | 22 |
| Ex. 17 | 90.0 | 0.0 | 0.0 | 10.0 | 0.0 | 0.0 | 10.0 | 1.4 | 25 |
| Ex. 18 | 88.0 | 0.0 | 0.0 | 12.0 | 0.0 | 0.0 | 12.0 | 1.8 | 28 |
| Ex. 19 | 98.0 | 0.0 | 0.0 | 0.0 | 2.0 | 0.0 | 2.0 | 1.4 | 14 |
| Ex. 20 | 96.0 | 0.0 | 0.0 | 0.0 | 4.0 | 0.0 | 4.0 | 1.0 | 16 |
| Ex. 21 | 94.0 | 0.0 | 0.0 | 0.0 | 6.0 | 0.0 | 6.0 | 0.6 | 18 |
| Ex. 22 | 92.0 | 0.0 | 0.0 | 0.0 | 8.0 | 0.0 | 8.0 | 1.0 | 21 |
| Ex. 23 | 90.0 | 0.0 | 0.0 | 0.0 | 10.0 | 0.0 | 10.0 | 1.4 | 24 |
| Ex. 24 | 88.0 | 0.0 | 0.0 | 0.0 | 12.0 | 0.0 | 12.0 | 1.8 | 27 |
| Ex. 25 | 98.0 | 1.0 | 1.0 | 0.0 | 0.0 | 0.0 | 2.0 | 1.3 | 15 |
| Ex. 26 | 96.0 | 2.0 | 2.0 | 0.0 | 0.0 | 0.0 | 4.0 | 0.9 | 17 |
| Ex. 27 | 94.0 | 3.0 | 3.0 | 0.0 | 0.0 | 0.0 | 6.0 | 0.5 | 20 |
| Ex. 28 | 92.0 | 4.0 | 4.0 | 0.0 | 0.0 | 0.0 | 8.0 | 0.9 | 23 |
| Ex. 29 | 90.0 | 5.0 | 5.0 | 0.0 | 0.0 | 0.0 | 10.0 | 1.3 | 26 |
| Ex. 30 | 88.0 | 6.0 | 6.0 | 0.0 | 0.0 | 0.0 | 12.0 | 1.7 | 29 |

| | | | | | | | | | |
|---|---|---|---|---|---|---|---|---|---|
| **A: First additive element(s)/(In + First additive element(s))** | | | | | | | | | |

### (Examples 31-60)

Examples 31-60 are ones in which the sintered compact composition of Example 1 was changed as shown in Table 2, while the other conditions are the same as Example 1. While Examples 1-30 are the cases where various dopants were added into indium oxide, Examples 31-60 are cases where various dopants were added to indium tin oxide. Tin oxide (SnO₂) was used as a source of Sn.

In these Examples, each of the films after deposition was amorphous, and when nickel, manganese, aluminum, germanium and nickel together with manganese were added, the resistivity of the film reduced once and then increased together with the increase in the concentration of each dopant or the total concentration of dopants. The minimum resistivity was given at about 6 at% of the dopant concentration.
Further, when tin was added, the resistivity of the films reduced more in comparison to the case where tin was not added. The resistivity of the films was adequately low, which were comparable to that of ITO film, and therefore they were adequate as a transparent conductive film.
On the other hand, the etching rate of the films increased monotonously as the addition amount of each dopant increases.

**[Table 2]**

| | Sintered compact comp. (atomic %) | | | | | | Rate (Atom %) | | Resistivity (mΩ cm) | Etching Rate (Å/sec) |
|---|---|---|---|---|---|---|---|---|---|---|
| | In | Ni | Mn | Al | Ge | Sn | A | B | | |
| Ex. 31 | 88.2 | 2.0 | 0.0 | 0.0 | 0.0 | 9.8 | 2.0 | 10.0 | 1.0 | 14 |
| Ex. 32 | 86.4 | 4.0 | 0.0 | 0.0 | 0.0 | 9.6 | 4.0 | 10.0 | 0.6 | 17 |
| Ex. 33 | 84.6 | 6.0 | 0.0 | 0.0 | 0.0 | 9.4 | 6.0 | 10.0 | 0.2 | 20 |
| Ex. 34 | 82.8 | 8.0 | 0.0 | 0.0 | 0.0 | 9.2 | 8.0 | 10.0 | 0.6 | 23 |
| Ex. 35 | 81.0 | 10.0 | 0.0 | 0.0 | 0.0 | 9.0 | 10.0 | 10.0 | 1.0 | 26 |
| Ex. 36 | 79.2 | 12.0 | 0.0 | 0.0 | 0.0 | 8.8 | 12.0 | 10.0 | 1.4 | 29 |
| Ex. 37 | 88.2 | 0.0 | 2.0 | 0.0 | 0.0 | 9.8 | 2.0 | 10.0 | 1.2 | 14 |
| Ex. 38 | 86.4 | 0.0 | 4.0 | 0.0 | 0.0 | 9.6 | 4.0 | 10.0 | 0.8 | 16 |
| Ex. 39 | 84.6 | 0.0 | 6.0 | 0.0 | 0.0 | 9.4 | 6.0 | 10.0 | 0.4 | 1 8 |
| Ex. 40 | 82.8 | 0.0 | 8.0 | 0.0 | 0.0 | 9.2 | 8.0 | 10.0 | 0.8 | 21 |
| Ex. 41 | 81.0 | 0.0 | 10.0 | 0.0 | 0.0 | 9.0 | 10.0 | 10.0 | 1.2 | 24 |
| Ex. 42 | 79.2 | 0.0 | 12.0 | 0.0 | 0.0 | 8.8 | 12.0 | 10.0 | 1.6 | 27 |
| Ex. 43 | 88.2 | 0.0 | 0.0 | 2.0 | 0.0 | 9.8 | 2.0 | 10.0 | 1.3 | 14 |
| Ex. 44 | 86.4 | 0.0 | 0.0 | 4.0 | 0.0 | 9.6 | 4.0 | 10.0 | 0.9 | 1 6 |
| Ex. 45 | 84.6 | 0.0 | 0.0 | 6.0 | 0.0 | 9.4 | 6.0 | 10.0 | 0.5 | 18 |
| Ex. 46 | 82.8 | 0.0 | 0.0 | 8.0 | 0.0 | 9.2 | 8.0 | 10.0 | 0.9 | 21 |
| Ex. 47 | 81.0 | 0.0 | 0.0 | 10.0 | 0.0 | 9.0 | 10.0 | 10.0 | 1.3 | 24 |
| Ex. 48 | 79.2 | 0.0 | 0.0 | 12.0 | 0.0 | 8.8 | 12.0 | 10.0 | 1.7 | 27 |
| Ex. 49 | 88.2 | 0.0 | 0.0 | 0.0 | 2.0 | 9.8 | 2.0 | 10.0 | 1.3 | 13 |
| Ex. 50 | 86.4 | 0.0 | 0.0 | 0.0 | 4.0 | 9.6 | 4.0 | 10.0 | 0.9 | 15 |
| Ex. 51 | 84.6 | 0.0 | 0.0 | 0.0 | 6.0 | 9.4 | 6.0 | 10.0 | 0.5 | 1 7 |
| Ex. 52 | 82.8 | 0.0 | 0.0 | 0.0 | 8.0 | 9.2 | 8.0 | 10.0 | 0.9 | 20 |
| Ex. 53 | 81.0 | 0.0 | 0.0 | 0.0 | 10.0 | 9.0 | 10.0 | 10.0 | 1.3 | 23 |
| Ex. 54 | 79.2 | 0.0 | 0.0 | 0.0 | 12.0 | 8.8 | 12.0 | 10.0 | 1.7 | 26 |
| Ex. 55 | 88.2 | 1.0 | 1.0 | 0.0 | 0.0 | 9.8 | 2.0 | 10.0 | 1.1 | 1 4 |
| Ex. 56 | 86.4 | 2.0 | 2.0 | 0.0 | 0.0 | 9.6 | 4.0 | 10.0 | 0.7 | 1 6 |
| Ex. 57 | 84.6 | 3.0 | 3.0 | 0.0 | 0.0 | 9.4 | 6.0 | 10.0 | 0.3 | 19 |
| Ex. 58 | 82.8 | 4.0 | 4.0 | 0.0 | 0.0 | 9.2 | 8.0 | 10.0 | 0.7 | 22 |
| Ex. 59 | 81.0 | 5.0 | 5.0 | 0.0 | 0.0 | 9.0 | 10.0 | 10.0 | 1.1 | 25 |
| Ex. 60 | 79.2 | 6.0 | 6.0 | 0.0 | 0.0 | 8.8 | 12.0 | 10.0 | 1.5 | 28 |

| | | | | | | | | | | |
|---|---|---|---|---|---|---|---|---|---|---|
| **A: First additive element(s) / (In + First additive element(s) + Sn)** **B: Sn / (In + Sn)** | | | | | | | | | | |

### (Comparative Examples 1-12)

Comparative Examples 1-12 are ones in which the sintered compact composition of Example 1 was changed as shown in Table 3, while the other conditions are the same as Example 1.

In Comparative Examples 1-5, the concentration of the first additive element was too low. Therefore, a portion of the film was crystallized after sputter deposition, and etching residue was generated when etching was performed.

In Comparative Examples 6-9, the concentration of the first additive element was too high. Therefore, the resistivity of the film was too high after sputter deposition, and thus, said film is not adequate as a transparent conductive film.

In Comparative Example 10, the concentration of tin was too low. Therefore a portion of the film was crystallized, and etching residue was generated when etching was performed.

In Comparative Example 11, the concentration of tin was adequate, and therefore the resistivity of the film was preferably low. However, a portion of the film was crystallized after sputter deposition because the first additive element is not contained. Thus, etching residue was generated when etching was performed.

In Comparative Example 12, the concentration of tin was too high, and the first additive element was not contained. Therefore, etching rate was very low. As the concentration of tin was high, the resistivity was also high.

**[Table 3]**

| | Sintered compact comp. (atomic %) | | | | | | Rate (Atom %) | | Resistivity (mΩ cm) | Etching Rate (Å/sec) |
|---|---|---|---|---|---|---|---|---|---|---|
| | In | Ni | Mn | Al | Ge | Sn | A | B | | |
| Comp. Ex.1 | 100.0 | 0.0 | 0.0 | 0.0 | 0.0 | 0.0 | 0.0 | 0.0 | 0.6 | 13 |
| Comp. Ex.2 | 99.0 | 1.0 | 0.0 | 0.0 | 0.0 | 0.0 | 1.0 | 0.0 | 1.3 | 13 |
| Comp. Ex.3 | 99.0 | 0.0 | 1.0 | 0.0 | 0.0 | 0.0 | 1.0 | 0.0 | 1.4 | 13 |
| Comp. Ex.4 | 99.0 | 0.0 | 0.0 | 1.0 | 0.0 | 0.0 | 1.0 | 0.0 | 1.4 | 13 |
| Comp. Ex.5 | 99.0 | 0.0 | 0.0 | 0.0 | 1.0 | 0.0 | 1.0 | 0.0 | 1.4 | 13 |
| Comp. Ex.6 | 86.0 | 14.0 | 0.0 | 0.0 | 0.0 | 0.0 | 14.0 | 0.0 | 4.0 | 35 |
| Comp. Ex.7 | 86.0 | 0.0 | 14.0 | 0.0 | 0.0 | 0.0 | 14.0 | 0.0 | 5.1 | 34 |
| Comp. Ex.8 | 86.0 | 0.0 | 0.0 | 14.0 | 0.0 | 0.0 | 14.0 | 0.0 | 5.2 | 34 |
| Comp. Ex.9 | 86.0 | 0.0 | 0.0 | 0.0 | 14.0 | 0.0 | 14.0 | 0.0 | 6.7 | 33 |
| Comp. Ex.10 | 99.0 | 0.0 | 0.0 | 0.0 | 0.0 | 1.0 | 0.0 | 1.0 | 0.8 | 13 |
| Comp. Ex.11 | 90.0 | 0.0 | 0.0 | 0.0 | 0.0 | 10.0 | 0.0 | 10.0 | 0.2 | 13 |
| Comp. Ex.12 | 80.0 | 0.0 | 0.0 | 0.0 | 0.0 | 20.0 | 0.0 | 20.0 | 1.8 | 7 |

| | | | | | | | | | | |
|---|---|---|---|---|---|---|---|---|---|---|
| **A: First additive element(s) / (In + First additive element(s) + Sn)** **B: Sn / (In + Sn)** | | | | | | | | | | |

## Claims

1. An oxide sintered compact containing indium oxide as a main component, while containing one or more elements selected from nickel, manganese, aluminum and germanium as a first additive element, with the total content of the first additive element being 2-12 atom % relative to the total content of indium and the first additive element.

2. An oxide sintered compact containing indium oxide as a main component, while containing one or more elements selected from nickel, manganese, aluminum and germanium as a first additive element, and further containing tin as a second additive element, with the total content of the first additive element being 2-12 atom % relative to the total content of indium the first additive element and tin, and the content of tin being 2-15 atom % relative to the total content of indium and tin.

3. A method of producing an amorphous film, wherein the oxide sintered compact according to claim 1 or 2 is used as a sputtering target and is sputtered.

4. An amorphous film having the same composition as that of the oxide sintered compact according to claim 1 or 2.
